# EUROPEAN PATENT SPECIFICATION

(11) **EP 3 091 571 B1**
(45) Date of publication and mention of the grant of the patent: **12.06.2019**
(21) Application number: 16166793.6
(22) Date of filing: 25.04.2016
(51) Int. Cl.: H01L 23/538, H01L 23/552, H01L 25/10, H01L 23/66, H01L 25/16

(54) **FAN-OUT PACKAGE STRUCTURE INCLUDING A CONDUCTIVE SHIELDING LAYER**
HALBLEITERVERPACKUNGSANORDNUNG MIT ABSCHIRMUNG
ENSEMBLE DE BOÎTIER DE SEMI-CONDUCTEURS AVEC UN BLINDAGE CONDUCTEUR

(30) Priority: 05.05.2015 US 201562157046 P; 17.11.2015 US 201562256218 P; 17.04.2016 US 201615130994
(43) Date of publication of application: 09.11.2016
(73) Proprietor: MediaTek Inc., Hsin-Chu 300 (TW)
(72) Inventor: LIN, Tzu-Hung, Zhubei City, Hsinchu County 302 (TW); PENG, I-Hsuan, Hsinchu City 300 (TW); LIU, Nai-Wei, Kaohsiung City 830 (TW); HSIAO, Ching-Wen, Hsinchu City 300 (TW); HUANG, Wei-Che, Hsinchu County 310 (TW)
(74) Representative: Goddar, Heinz J.

(56) References cited:
- EP-A1- 1 648 028
- WO-A2-2009/035962
- US-A1- 2012 133 032
- US-A1- 2013 009 320

## Description

### Field of the Invention

The present invention relates to a semiconductor package structure, and in particular to a fan-out package structure including a conductive shielding layer.

### Description of the Related Art

In order to ensure the continued miniaturization and multi-functionality of electronic products and communication devices, it is desired that semiconductor packages be small in size, support multi-pin connection, operate at high speeds, and have high functionality. Additionally, in a high frequency application, such as a radio frequency (RF) system-in-package (SiP) assembly, antennas are typically used for enabling wireless communication.

In such a conventional SiP structure, a discrete antenna component is individually encapsulated or mounted on a printed circuit board (PCB) or package. However, the PCB is required to provide additional area for the antenna component mounted thereon. As a result, it is difficult to reduce the device size. Additionally, the total height of the SiP structure is increased when the antenna component is mounted on the package. Moreover, in this case, since the antenna component is typically mounted on the package by a surface mount technology (SMT) process, poor SMT process control may induce delamination between the antenna component and the underlying package. As a result, reliability, yield, and throughput of the semiconductor package structure are reduced.

Thus, a novel semiconductor package structure is desirable.

WO2009/0359621 describes a semiconductor package having an electromagnetic shield. The package comprises a semiconductor die, a redistribution layer connected to the semiconductor die, a molding compound encapsulating the semiconductor die and an inter metal dielectric structure disposed on the molding compound and including a conductive shielding layer.

US2013/0009320A1 describes a semiconductor package structure having a semiconductor die, a redistribution layer connected to the semiconductor die, a molding compound encapsulating the semiconductor die, and an inter metal dielectric structure disposed on the molding compound. A conductive layer having an antenna pattern is provided inter metal dielectric structure.

A structure according to the preamble of claim 1 is known from US 2012/0 133 032 A1. This document teaches to perform a cutting process to obtain a plurality of separate package units and to form a metal layer on the exposed surfaces of the encapsulant and the side surfaces of the substrate of each packet unit, each packet unit including one die. Similar prior art is described in EP 1 648 028 A1.

### BRIEF SUMMARY OF THE INVENTION

The present invention provides a semiconductor package structure according to claim 1.

Embodiments of the invention are defined in the dependent claims.

A detailed description is given in the following embodiments with reference to the accompanying drawings.

### BRIEF DESCRIPTION OF THE DRAWINGS

The present invention can be more fully understood by reading the subsequent detailed description and examples with references made to the accompanying drawings, wherein:
FIG. 1A is a cross-sectional view of a semiconductor package structure, not according to the invention.
FIG. 1B is a plan view of an IMD structure of the semiconductor package structure shown in FIG. 1A.
FIG. 2 is a cross-sectional view of a semiconductor package structure with two semiconductor dies arranged side-by-side, not according to the invention.
FIG. 3 is a cross-sectional view of a semiconductor package structure with a package on package (PoP) structure, not according to the invention.
FIG. 4A is a cross-sectional view of a semiconductor package structure, not according to the invention.
FIG. 4B is a plan view of an IMD structure of the semiconductor package structure shown in FIG. 4A.
FIG. 5 is a cross-sectional view of an exemplary semiconductor package structure with two semiconductor dies arranged side-by-side in accordance with the invention.
FIG. 6 is a cross-sectional view of a semiconductor package structure with a package on package (PoP) structure in accordance with some examples of the disclosure, not according to the invention.

### DETAILED DESCRIPTION

The following description is of the best-contemplated mode of carrying out the invention. This description is made for the purpose of illustrating the general principles of the invention and should not be taken in a limiting sense. The scope of the invention is determined by reference to the appended claims.

The present invention will be described with respect to particular examples and with reference to certain drawings, but the invention is not limited thereto and is only limited by the claims. The drawings described are only schematic and are non-limiting. In the drawings, the size of some of the elements may be exaggerated for illustrative purposes and not drawn to scale. The dimensions and the relative dimensions do not correspond to actual dimensions in the practice of the invention.

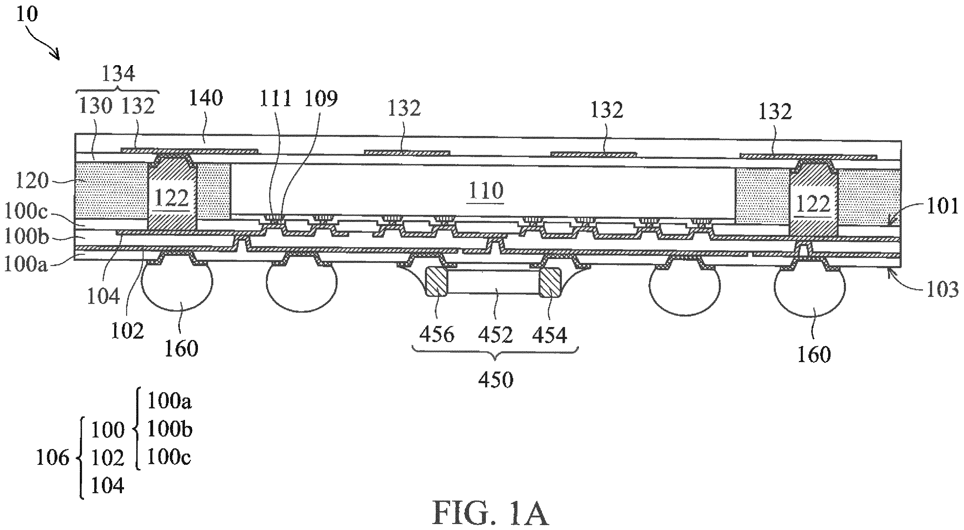

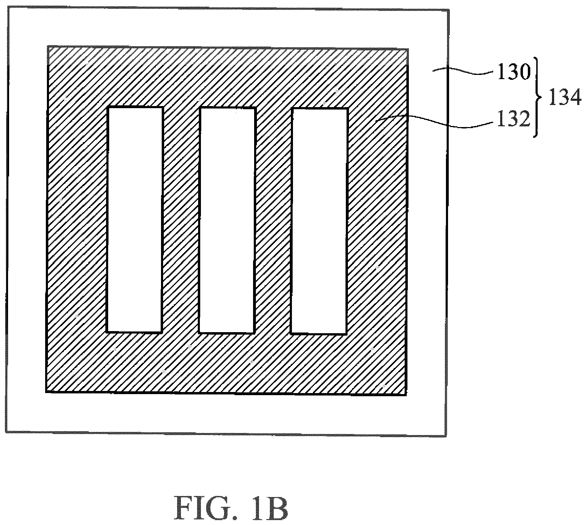

FIG. 1A is a cross-sectional view of a semiconductor package structure 10 in accordance with some examples of the disclosure. FIG. 1B is a plan view of an IMD structure 134 of the semiconductor package structure 10 shown in FIG. 1A. In some examples, the semiconductor package structure 10 is a wafer-level semiconductor package structure, for example, a flip-chip semiconductor package structure.

Referring to FIG. 1A, the semiconductor package structure 10 includes a first semiconductor package, such as a wafer-level semiconductor package, that may be mounted on a base (not shown). In some examples, the first semiconductor package may include a system-on-chip (SOC) package. Moreover, the base may include a printed circuit board (PCB) and may be formed of polypropylene (PP). In some examples, the base may include a package substrate. The first semiconductor package of the semiconductor package structure 10 is mounted on the base by a bonding process. For example, the first semiconductor package includes a plurality of first conductive structures 160 that is mounted on and electrically coupled to the base by the bonding process.

The first semiconductor package includes a first semiconductor die 110 and a first RDL structure 106. The first semiconductor die 110, for example, may include a microcontroller (MCU), a microprocessor (MPU), a random access memory (RAM), a power management integrated circuit (PMIC), a flash memory, a global positioning system (GPS) device, or a radio frequency (RF) device or any combination thereof. Moreover, for example, the first conductive structures 160 may comprise a conductive bump structure such as a copper bump or a solder bump structure, a conductive pillar structure, a conductive wire structure, or a conductive paste structure.

As shown in FIG. 1A, the first semiconductor die 110 is fabricated by flip-chip technology. Pads 109 of the first semiconductor die 110 are electrically connected to the circuitry (not shown) of the first semiconductor die 110. In some examples, the pads 109 belong to the uppermost metal layer of the interconnection structure (not shown) of the first semiconductor die 110. The pads 109 of the first semiconductor die 110 are in contact with the corresponding conductive structures 111, for example, conductive bumps, posts or solder pastes. It should be noted that the number of semiconductor dies integrated in the semiconductor package structure 10 is not limited to that disclosed in the example.

The first RDL structure 106, which is also referred to as a fan-out structure, has a first surface 101 and a second surface 103 opposite thereto. The first semiconductor die 110 is disposed on the first surface 101 of the first RDL structure 106. The first semiconductor die 110 is connected to the first RDL structure 106 through the conductive structures 111.

In the example, the first RDL structure 106 includes one or more conductive traces disposed in an inter-metal dielectric (IMD) layer 100. For example, a plurality of first conductive traces 104 is disposed at a first layer-level of the IMD layer 100 and at least one of the first conductive traces 104 is electrically coupled to the first semiconductor die 110. Moreover, a plurality of second conductive traces 102 is disposed at a second layer-level different from the first layer-level of the IMD layer 100. In this case, the IMD layer 100 may include first, second, and third sub-dielectric layers 100a, 100b, and 100c successively stacked from the second surface 103 of the first RDL structure 106 toward the first surface 101 of the first RDL structure 106, such that the first conductive traces 104 are positioned on the third sub-dielectric layer 100c and the second conductive traces 102 are positioned on the second sub-dielectric layer 100b and covered by the first sub-dielectric layer 100a. Also, the first conductive traces 104 are separated from the second conductive traces 102 by the second sub-dielectric layer 100b. In some examples, the IMD layer 100 may be formed of organic materials, which include a polymer base material, non-organic materials, which include silicon nitride (SiNx), silicon oxide (SiOx), graphene, or the like. For example, the first, second, third sub-dielectric layers 100a, 100b, and 100c are made of a polymer base material.

In some examples, the IMD layer 100 is a high-k dielectric layer (k is the dielectric constant of the dielectric layer). In some other examples, the IMD layer 100 may be formed of a photo sensitive material, which includes a dry film photoresist, or a taping film.

Pad portions of the second conductive traces 102 are exposed to openings of the first sub-dielectric layers 100a and connected to the first conductive structures 160 that are disposed on the second surface 103 of the first RDL structure 106. Also, it should be noted that the number of conductive traces and the number of sub-dielectric layers of the first RDL structure 106 shown in FIG. 1A is only an example.

In the example, the first semiconductor package further includes at least one electronic component 450, such as an integrated passive device (IPD), disposed on the second surface 103 of the first RDL structure 106. The IPD is electrically coupled to the first semiconductor die 110 through the first RDL structure 106. In some examples, the IPD may include a capacitor, an inductor, a resistor, or a combination thereof. Moreover, the IPD includes at least one electrode electrically coupled to one of the second conductive traces 102. For example, the electronic component 450 may be a capacitor that is electrically coupled to the first semiconductor die 110. In this case, the capacitor includes a body 452 and first and second electrode layers 454 and 456 respectively disposed on two ends of the body 452. Moreover, the first and second electrode layers 454 and 456 are respectively electrically coupled to at least two of the second conductive traces 102.

In the example, as shown in FIG. 1A, the first semiconductor package further includes a first molding compound 120 disposed on the first surface 101 of the first RDL structure 106 and surrounding the first semiconductor die 110. In some examples, the first molding compound 120 may be formed of an epoxy, a resin, a moldable polymer, or the like. The first molding compound 120 may be applied while substantially liquid, and then may be cured through a chemical reaction, such as in an epoxy or resin. In some other examples, the first molding compound 120 may be an ultraviolet (UV) or thermally cured polymer applied as a gel or malleable solid capable of being disposed around the first semiconductor die 110, and then may be cured through a UV or thermal curing process. The first molding compound 120 may be cured with a mold (not shown).

In the example, the first molding compound 120 includes first vias 122 passing through it. The first vias 122 are electrically coupled to the first conductive traces 104 of the first RDL structure 106. Moreover, the first semiconductor die 110 may be surrounded by the first vias 122. In some examples, the first vias 122 may comprise through package vias (TPVs) formed of copper.

The first conductive structures 160 are separated from the first molding compound 120 through the first RDL structure 106. In other words, the first conductive structures 160 are free from contact with the first molding compound 120. In some examples, the first conductive structures 160 may comprise a conductive bump structure (such as a copper or solder bump structure), a conductive pillar structure, a conductive wire structure, or a conductive paste structure.

In the example, as shown in FIG. 1A, the first semiconductor package further includes an IMD structure 134 disposed on the first molding compound 120 and the first semiconductor die 110. The methods and materials used for forming the IMD structure 134 may be the same as or similar to those of the first RDL structure 106. In other words, the process for forming the first RDL structure 106 can be used for forming the IMD structure 134. In the example, the IMD structure 134 includes a conductive layer 132 with an antenna pattern disposed on a dielectric layer 130 and electrically coupled to the first RDL structure 106 through the first vias 122. In some examples, the conductive layer 132 with an antenna pattern may be embedded within the dielectric layer 130. The methods and materials used for forming the conductive layer 132 with an antenna pattern may be the same as or similar to those of the first conductive traces 104 and the second conductive traces 102. Moreover, the dielectric layer 130 may be a single layer or a multi-layer structure. Also, the methods and materials used for forming the dielectric layer 130 may be the same as or similar to those of the first, second, or third sub-dielectric layer 100a, 100b, or 100c.

In the example, the antenna pattern of the conductive layer 132 is a fence pattern in a top view, as shown in FIG. 1B. However, it should be understood that those of ordinary skill in the art know that various shapes can be used for the antenna pattern of the conductive layer 132. The conductive layer 132 with an antenna pattern enables wireless communication for the semiconductor package structure 10.

In the example, as shown in FIG. 1A, the first semiconductor package further includes an optional passivation layer 140 covering the IMD structure 134, so as to protect the conductive layer 132 with an antenna pattern from damage. The passivation layer 140 may be composed of a material that is the same as or different from that of the dielectric layer 130. For example, the passivation layer 140 may comprise an epoxy, a solder mask, an inorganic material (e.g., silicon nitride (SiNX), silicon oxide (SiOX), graphene, or the like), or an organic polymer base material. In cases where the conductive layer 132 with an antenna pattern is embedded within the dielectric layer 130, the passivation layer 140 may be omitted.

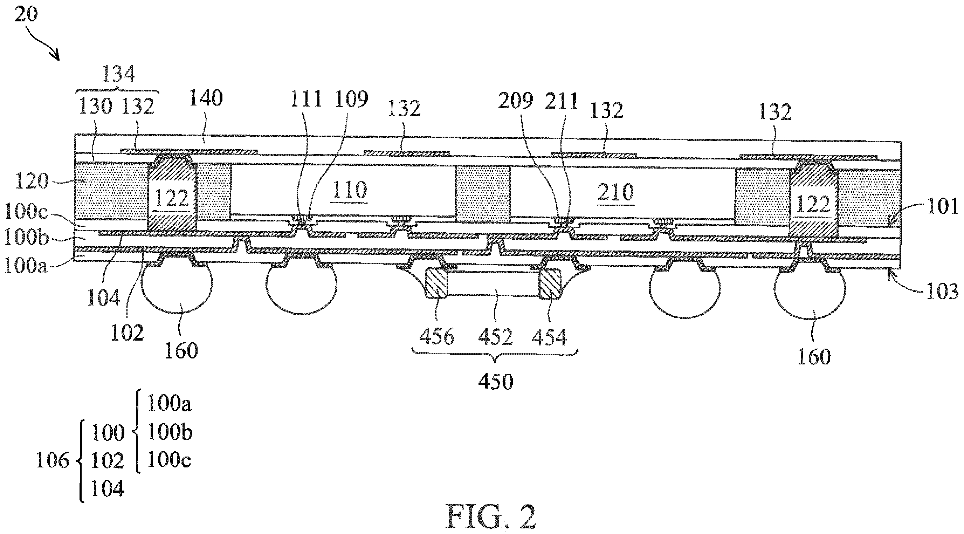

FIG. 2 is a cross-sectional view of a semiconductor package structure 20 with first and second semiconductor dies 110 and 210 arranged side-by-side in accordance with some examples of the disclosure. Descriptions of elements of the examples hereinafter that are the same as or similar to those previously described with reference to FIG. 1A are omitted for brevity. In the example, the semiconductor package structure 20 is similar to the semiconductor package structure 10 shown in FIG. 1A, except that the first semiconductor package of the semiconductor package structure 20 further includes a second semiconductor die 210 disposed on the first surface 101 of the first RDL structure 106 and surrounded by the first molding compound 120 and the first vias 122. In the example, the first and second semiconductor dies 110 and 210 are arranged side-by-side. Pads 209 of the second semiconductor die 210 are electrically connected to the circuitry (not shown) of the second semiconductor die 210. In some examples, the pads 209 belong to the uppermost metal layer of the interconnection structure (not shown) of the second semiconductor die 210. The pads 209 of the second semiconductor die 210 are in contact with the corresponding conductive structures 211, for example, conductive bumps, posts or solder pastes. The second semiconductor die 210 is electrically coupled to the first semiconductor die 110 through the pads 209, conductive structures 211, and the first RDL structure 106. It should be noted that the number of semiconductor dies integrated in the semiconductor package structure 20 is not limited to that disclosed in the example.

In some examples, the second semiconductor die 210 may include an MCU), an MPU, a RAM, a PMIC, a flash memory, a GPS device, or an RF device or any combination thereof. In some examples, at least one of the first and second semiconductor dies 110 and 210 is a SOC die. For example, the first and second semiconductor dies 110 and 210 are SOC dies. Alternatively, the first semiconductor die 110 is a SOC die, and the second semiconductor die 210 is a memory die. Therefore, the first semiconductor package of the semiconductor package assembly 20 may include a pure SOC package or a hybrid SOC package. However, the number and the arrangement of semiconductor dies are not limited to the disclosed example.

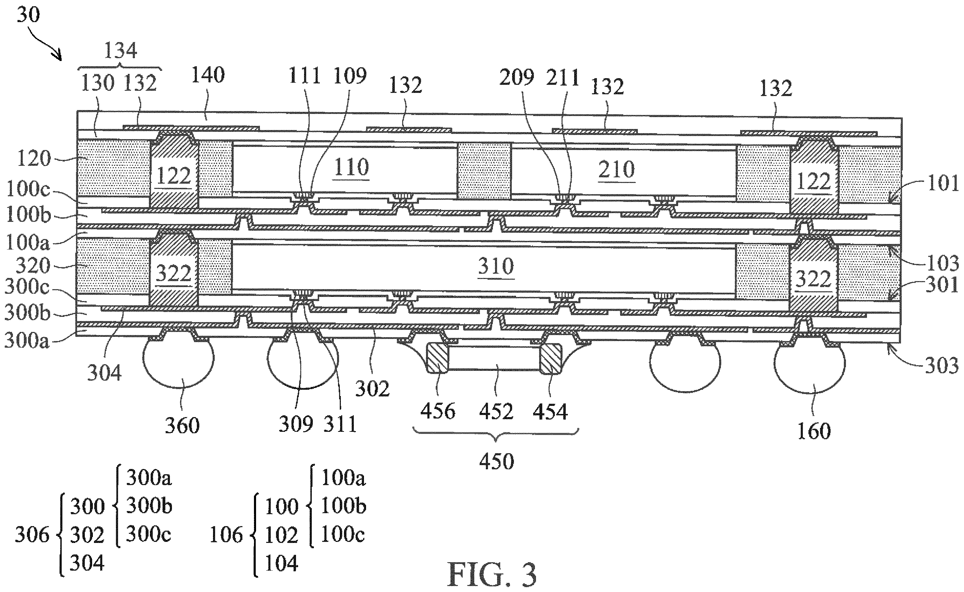

FIG. 3 is a cross-sectional view of a semiconductor package structure 30 with a package on package (PoP) structure in accordance with some examples of the disclosure. Descriptions of elements of the examples hereinafter that are the same as or similar to those previously described with reference to FIGS. 1A and 2 are omitted for brevity. In the example, the semiconductor package structure 30 is similar to the semiconductor package structure 20 shown in FIG. 2, except that the semiconductor package structure 30 further includes a second semiconductor package stacked below the first semiconductor package of the semiconductor package structure 20. In some examples, the semiconductor package structure 30 is similar to the semiconductor package structure 10 shown in FIG. 1A, except that the semiconductor package structure 30 further includes a second semiconductor package stacked below the first semiconductor package of the semiconductor package structure 10.

In the example, the second semiconductor package has a structure similar to that of the first semiconductor package of the semiconductor package structure 10 shown in FIG. 1A. The second semiconductor package, such as a wafer-level semiconductor package, that may be mounted on a base (not shown). In some examples, the second semiconductor package may include a SOC package. Moreover, the second semiconductor package of the semiconductor package structure 30 is mounted on the base via a plurality of second conductive structures 360 using a bonding process. The second conductive structures 360 may be the same as or similar to the first conductive structures 160.

The second semiconductor package includes a third semiconductor die 310 and a second RDL structure 306. The third semiconductor die 310, for example, may include an MCU, an MPU, a RAM, a PMIC, a flash memory, a GPS device, or a RF device or any combination thereof. Similarly, the third semiconductor die 310 is fabricated by flip-chip technology. Pads 309 of the third semiconductor die 310 are electrically connected to the circuitry (not shown) of the third semiconductor die 310. In some examples, the pads 309 belong to the uppermost metal layer of the interconnection structure (not shown) of the third semiconductor die 310. The pads 309 of the third semiconductor die 310 are in contact with the corresponding conductive structures 311, for example, conductive bumps, posts or solder pastes. It should be noted that the number of semiconductor dies integrated in the second semiconductor package is not limited to that disclosed in the example.

The second RDL structure 306, which is also referred to as a fan-out structure, has a third surface 301 and a fourth surface 603 opposite thereto. The third semiconductor die 310 is disposed on the third surface 301 of the second RDL structure 306. The third semiconductor die 310 is connected to the second RDL structure 306 through the conductive structures 311.

In the example, the second RDL structure 306 has a structure that is the same as or similar to that of the first RDL structure 106. For example, a plurality of first conductive traces 304 is disposed at a first layer-level of the IMD layer 300 and at least one of the first conductive traces 304 is electrically coupled to the third semiconductor die 310. Moreover, a plurality of second conductive traces 302 is disposed at a second layer-level different from the first layer-level of the IMD layer 300. In this case, the IMD layer 300 may include first, second, and third sub-dielectric layers 300a, 300b, and 300c successively stacked from the second surface 303 of the second RDL structure 306 toward the first surface 301 of the second RDL structure 306, such that the first conductive traces 304 are positioned on the third sub-dielectric layer 300C and the second conductive traces 302 are positioned on the second sub-dielectric layer 300b and covered by the first sub-dielectric layer 300a. Also, the first conductive traces 304 are separated from the second conductive traces 302 by the second sub-dielectric layer 300b. In some examples, the IMD layer 300 may be formed of a material that is the same as or similar to that of the IMD layer 100.

Pad portions of the second conductive traces 302 are exposed to openings of the first sub-dielectric layers 300a and connected to the second conductive structures 360 that are disposed on the second surface 303 of the second RDL structure 306. Also, it should be noted that the number of conductive traces and the number of sub-dielectric layers of the second RDL structure 306 shown in FIG. 3 is only an example.

In the example, the second semiconductor package further includes an electronic component 450 that is disposed on the fourth surface 303 of the second RDL structure 306. The electronic component 450, such as a capacitor, includes a body 452 and first and second electrode layers 454 and 456 respectively disposed on two ends of the body 452 and respectively electrically coupled to at least two of the second conductive traces 302.

In the example, as shown in FIG. 3, the second semiconductor package further includes a second molding compound 320 disposed on the first surface 301 of the second RDL structure 306 and surrounding the third semiconductor die 310. In some examples, the second molding compound 320 may be formed of a material that is the same as or similar to that of first molding compound 120.

In the example, the second molding compound 320 includes second vias 322 passing through it. The second vias 322 are electrically coupled to the first conductive traces 304 of the second RDL structure 306, so as to form an electrical connection between the first and second RDL structures 106 and 306. Moreover, the third semiconductor die 310 may be surrounded by the second vias 322. In some examples, the second vias 322 may comprise TPVs formed of copper. Also, the second conductive structures 360 are separated from the second molding compound 320 through the second RDL structure 306.

According to the foregoing examples, the semiconductor package structure is designed to fabricate an antenna integrated into the first semiconductor package(s). The antenna provides wireless communication and a compatible process for the semiconductor package structure. Accordingly, there is no need to perform an SMT process for forming the antenna device. As a result, reliability, yield, and throughput of the semiconductor package structure are increased and the manufacturing cost of the semiconductor package structure is reduced. Additionally, the integrated antenna can provide design flexibility for the system integration of the semiconductor package structure.

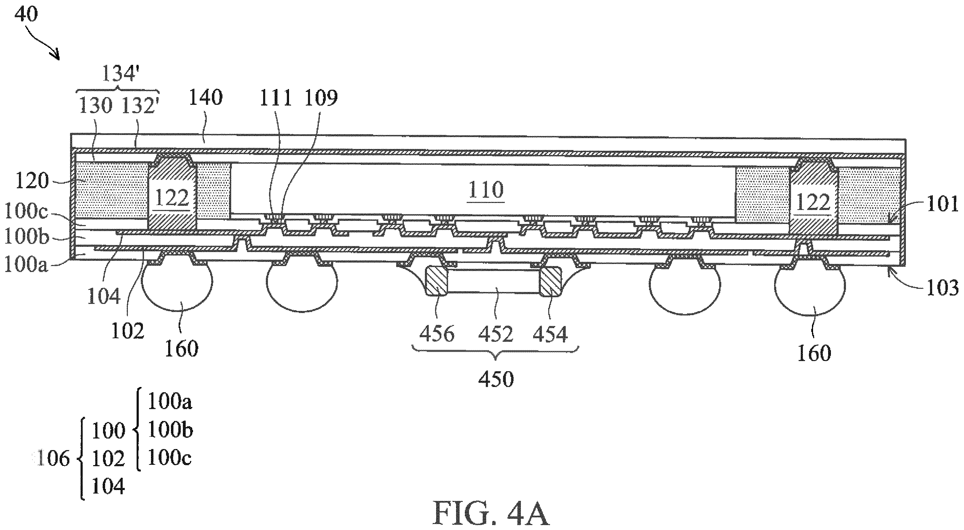

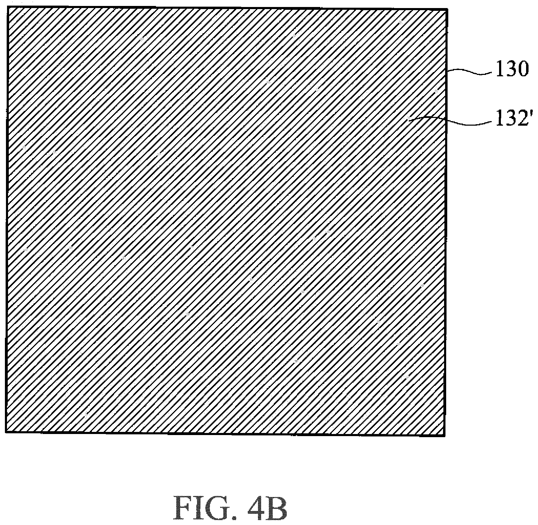

FIG. 4A is a cross-sectional view of a semiconductor package structure 40 in accordance with some examples of the disclosure. FIG. 4B is a plan view of an IMD structure 134' of the semiconductor package structure 40 shown in FIG. 4A. Descriptions of elements of the examples hereinafter that are the same as or similar to those previously described with reference to FIGS. 1A and 1B are omitted for brevity. In the example, the semiconductor package structure 40 is similar to the semiconductor package structure 10 shown in FIG. 1A, except that the IMD structure 134' of the semiconductor package structure 40 has a conductive shielding layer 132' that covers the first semiconductor die 110 and is uncovered by any passivation layer. As shown in FIG. 4B, unlike the conductive layer 132 with an antenna pattern shown in FIG. 1A, the conductive shielding layer 132' is a solid/continuous layer without any pattern/opening therein. The conductive shielding layer 132' is disposed on and substantially covers the entire upper surface of the dielectric layer 130. Moreover, the conductive shielding layer 132' further extends along the sidewalls of the dielectric layer 130, the first molding compound 120, and the IMD layer 100 to the second surface 103 of the first RDL structure 106, so that the sidewall of the semiconductor package structure 40 is substantially covered by the conductive shielding layer 132'. In the example, the conductive shielding layer 132' is electrically coupled to at least one of the first vias 122. The conductive shielding layer 132' is employed to reduce electrical noise from affecting the signals, and to reduce electromagnetic radiation that may interfere with other devices.

In the example, the methods and materials used for forming the IMD structure 134' are the same as or similar to those of the IMD structure 134 shown in FIG. 1A. In other words, the methods and materials used for forming the conductive shielding layer 132' are the same as or similar to those of the conductive layer 132 with an antenna pattern shown in FIG. 1A.

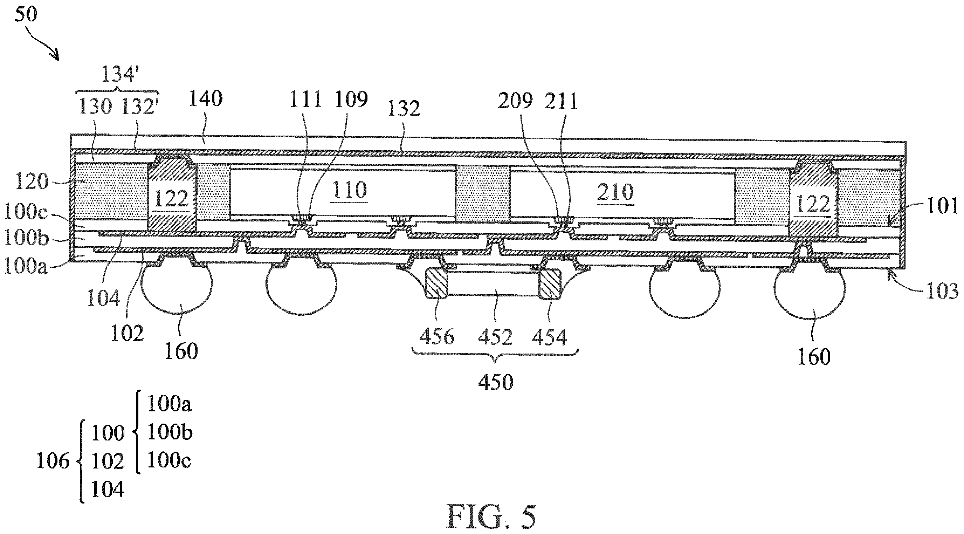

FIG. 5 is a cross-sectional view of an exemplary semiconductor package structure 50 with first and second semiconductor dies 110 and 210 arranged side-by-side in accordance with some embodiments of the disclosure. Descriptions of elements of the embodiments hereinafter that are the same as or similar to those previously described with reference to FIGS. 4A and 2 are omitted for brevity. In the embodiment, the semiconductor package structure 50 is similar to the semiconductor package structure 20 shown in FIG. 2, except that the IMD structure 134' of semiconductor package structure 50 has a conductive shielding layer 132' that covers the first and second semiconductor dies 110 and 210 and is uncovered by any passivation layer. Also, as shown in FIG. 5, the conductive shielding layer 132' further extends along the sidewalls of the dielectric layer 130, the first molding compound 120, and the IMD layer 100 to the second surface 103 of the first RDL structure 106, so that the sidewall of the semiconductor package structure 50 is substantially covered by the conductive shielding layer 132'. In the embodiment, the conductive shielding layer 132' is electrically coupled to at least one of the first vias 122 to reduce electrical noise from affecting the signals, and to reduce electromagnetic radiation that may interfere with other devices.

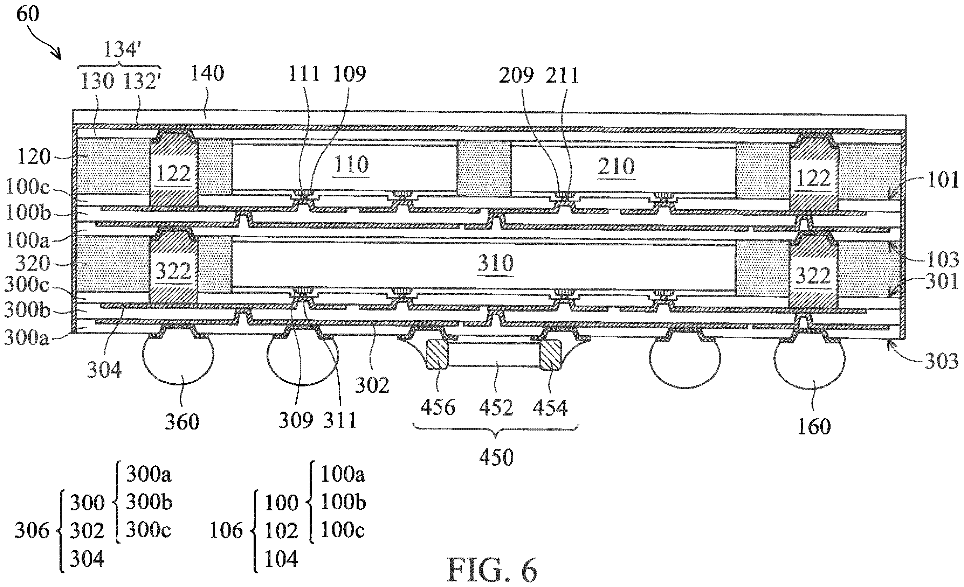

FIG. 6 is a cross-sectional view of a semiconductor package structure 60 with a PoP structure in accordance with some embodiments of the disclosure. Descriptions of elements of the embodiments hereinafter that are the same as or similar to those previously described with reference to FIGS. 4A and 3 are omitted for brevity. In the embodiment, the semiconductor package structure 60 is similar to the semiconductor package structure 30 shown in FIG. 3, except that the IMD structure 134' of semiconductor package structure 60 has a conductive shielding layer 132' that covers the first and second semiconductor dies 110 and 210 and is uncovered by any passivation layer. Similarly, as shown in FIG. 6, the conductive shielding layer 132' further extends along the sidewalls of the dielectric layer 130, the first molding compound 120, the IMD layer 100, the second molding compound 320, and the IMD layer 300 to the second surface 103 of the second RDL structure 306, so that the sidewall of the semiconductor package structure 60 is substantially covered by the conductive shielding layer 132'. In the embodiment, the conductive shielding layer 132' is electrically coupled to at least one of the first vias 122 to reduce electrical noise from affecting the signals, and to reduce electromagnetic radiation that may interfere with other devices.

According to the foregoing embodiments, the semiconductor package structure is designed to fabricate a shielding layer integrated into the semiconductor package(s). The shielding layer provides the function of reducing electrical noise and electromagnetic radiation and a compatible process for the semiconductor package structure. Accordingly, there is no need to perform an additional process for forming the shielding device. As a result, reliability, yield, and throughput of the semiconductor package structure are increased and the manufacturing cost of the semiconductor package structure is reduced. Additionally, the integrated shielding layer can provide design flexibility for the system integration of the semiconductor package structure.

## Claims

1. A semiconductor package structure, comprising:
a first semiconductor package, comprising:
a first redistribution layer (RDL) structure (106) having a first surface (101) and a second surface (103) opposite thereto;
a first semiconductor die (110) disposed on the first surface (101) of the first RDL structure (106);
a first molding compound (120) disposed on the first surface (101) of the first RDL structure (106) and surrounding the first semiconductor die (110); and
an inter-metal dielectric (IMD) structure (134') disposed on the first molding compound (120) and the first semiconductor die (110), wherein the IMD structure (134') comprises a dielectric layer (130) and a conductive shielding layer (132') covering the first semiconductor die (110);
wherein the conductive shielding layer (132') is disposed on and covers the entire upper surface of the dielectric layer (130) and extends along the sidewalls of the dielectric layer (130), the first molding compound (120), and the first RDL structure (106) to the second surface (103) of the first RDL structure (106) so that the sidewall of the semiconductor package structure is substantially covered by the conductive shielding layer (132');
wherein the first semiconductor package further comprises a second semiconductor die (210) disposed on the first surface (101) of the first RDL structure (106), such that the first and second semiconductor dies (110, 210) are arranged side-by-side wherein the second semiconductor die is covered by the conductive shielding layer (132');
wherein the first semiconductor package further comprises a plurality of first vias (122) passing through the first molding compound (120) and electrically coupled to the first RDL structure (106);
**characterized in that** at least one of said first vias (122) is coupled to the conductive shielding layer (132') covering the first semiconductor die(132).

2. The semiconductor package structure of claim 1, wherein the first semiconductor package further comprises a plurality of first conductive structures (160) disposed on the second surface (103) of the first RDL structure (106) and electrically coupled to the first RDL structure (106).

3. The semiconductor package structure of one of the preceding claims, wherein at least one of the semiconductor dies (110) comprises a microcontroller, a microprocessor, a random access memory, a power management integrated circuit, a flash memory, a global positioning system device, or a radio frequency device.

## Patentansprüche

1. Halbleiterpackageanordnung, umfassend:
ein erstes Halbleiterpackage, umfassend:
eine erste Redistributionsschichtstruktur (RDL-Struktur) (106) mit einer ersten Oberfläche (101) und einer dieser entgegengesetzten zweiten Oberfläche (103);
ein erstes Halbleiter-Die (110), das auf der ersten Oberfläche (101) der ersten RDL-Struktur (106) angeordnet ist;
eine erste Formmasse (120), die auf der ersten Oberfläche (101) der ersten RDL-Struktur (106) angeordnet ist und das erste Halbleiter-Die (110) umgibt; und
eine Zwischenmetalldielektrikumstruktur (IMD-Struktur) (134'), die auf der ersten Formmasse (120) und dem ersten Halbleiter-Die (110) angeordnet ist, wobei die IMD-Struktur (134') eine Dielektrikumschicht (130) und eine leitfähige Abschirmschicht (132'), die das erste Halbleiter-Die (110) bedeckt, umfasst;
wobei die leitfähige Abschirmschicht (132') auf der gesamten oberen Oberfläche der Dielektrikumschicht (130) angeordnet ist, diese bedeckt und sich entlang den Seitenwänden der Dielektrikumschicht (130), der ersten Formmasse (120) und der ersten RDL-Struktur (106) zu der zweiten Oberfläche (103) der ersten RDL-Struktur (106) erstreckt, so dass die Seitenwand der Halbleiterpackageanordnung im Wesentlichen von der leitfähigen Abschirmschicht (132') bedeckt ist;
wobei das erste Halbleiterpackage ferner ein zweites Halbleiter-Die (210) umfasst, das auf der ersten Oberfläche (101) der ersten RDL-Struktur (106) derart angeordnet ist, dass das erste und das zweite Halbleiter-Die (110, 210) Seite an Seite angeordnet sind,
wobei das zweite Halbleiter-Die durch die leitfähige Abschirmschicht (132') bedeckt ist;
wobei das erste Halbleiterpackage ferner mehrere erste Durchkontaktierungen (122) umfasst, die durch die erste Formmasse (120) verlaufen und mit der ersten RDL-Struktur (106) elektrisch gekoppelt sind;
**dadurch gekennzeichnet, dass**
mindestens eine der ersten Durchkontaktierungen (122) mit der leitfähigen Abschirmschicht (132') gekoppelt ist, welche das erste Halbleiter-Die (132) bedeckt.

2. Halbleiterpackageanordnung nach Anspruch 1, wobei das erste Halbleiterpackage ferner mehrere erste leitfähige Strukturen (160) umfasst, die auf der zweiten Oberfläche (103) der ersten RDL-Struktur (106) angeordnet und mit der ersten RDL-Struktur (106) elektrisch gekoppelt sind.

3. Halbleiterpackageanordnung nach einem der vorhergehenden Ansprüche, wobei mindestens eines der Halbleiter-Dies (110) einen Mikrocontroller, einen Mikroprozessor, einen Direktzugriffsspeicher, eine integrierte Leistungsmanagementschaltung, einen Flash-Speicher, eine GPS-Vorrichtung oder eine Hochfrequenzvorrichtung umfasst.

## Revendications

1. Structure de composant à semi-conducteur, comprenant :
un premier composant à semi-conducteur, comprenant :
une première structure de couche de redistribution (RDL) (106) ayant une première surface (101) et une deuxième surface (103) opposée à celle-ci ;
une première puce à semi-conducteur (110) disposée sur la première surface (101) de la première structure RDL (106) ;
un premier composé de moulage (120) disposé sur la première surface (101) de la première structure RDL (106) et entourant la première puce à semi-conducteur (110) ; et
une structure diélectrique intermétallique (IMD) (134') disposée sur le premier composé de moulage (120) et la première puce à semi-conducteur (110), dans laquelle la structure IMD (134') comprend une couche diélectrique (130) et une couche de blindage conducteur (132') recouvrant la première puce à semi-conducteur (110) ;
dans laquelle la couche de blindage conducteur (132') est disposée sur et recouvre la surface supérieure entière de la couche diélectrique (130) et s'étend le long des parois latérales de la couche diélectrique (130), le premier composé de moulage (120), et la première structure RDL (106) jusqu'à la deuxième surface (103) de la première structure RDL (106) de sorte que la paroi latérale de la structure de composant à semi-conducteur soit sensiblement recouverte par la couche de blindage conducteur (132') ;
dans laquelle le premier composant à semi-conducteur comprend en outre une deuxième puce à semi-conducteur (210) disposée sur la première surface (101) de la première structure RDL (106), de sorte que les première et deuxième puces à semi-conducteur (110, 210) soient agencées côte-à-côte, la deuxième puce à semi-conducteur étant recouverte par la couche de blindage conducteur (132') ;
dans laquelle le premier composant à semi-conducteur comprend en outre une pluralité de premiers trous d'interconnexion (122) traversant le premier composé de moulage (120) et électriquement couplés à la première structure RDL (106) ;
**caractérisée en ce que**
au moins l'un desdits premiers trous d'interconnexion (122) est couplé à la couche de blindage conducteur (132') recouvrant la première puce à semi-conducteur (132).

2. Structure de composant à semi-conducteur selon la revendication 1, dans laquelle le premier composant à semi-conducteur comprend en outre une pluralité de premières structures conductrices (160) disposées sur la deuxième surface (103) de la première structure RDL (106) et électriquement couplées à la première structure RDL (106).

3. Structure de composant à semi-conducteur selon l'une des revendications précédentes, dans laquelle au moins l'une des puces à semi-conducteur (110) comprend un microcontrôleur, un microprocesseur, une mémoire vive, un circuit intégré de gestion d'alimentation, une mémoire flash, un dispositif GPS, ou un dispositif à radiofréquence.
